(19) Europäisches Patentamt
European Patent Office
Office européen des brevets

(11) Publication number : **0 530 095 A1**

# (12) EUROPEAN PATENT APPLICATION

(21) Application number : **92402336.9**

(51) Int. Cl.$^5$ : **C08F 2/50**, G03F 7/029

(22) Date of filing : **25.08.92**

(30) Priority : **26.08.91 US 750879**

(43) Date of publication of application : **03.03.93 Bulletin 93/09**

(84) Designated Contracting States : **BE CH DE FR GB IT LI NL**

(71) Applicant : **MINNESOTA MINING AND MANUFACTURING COMPANY**
**3M Center, P.O. Box 33427**
**St. Paul, Minnesota 55133-3427 (US)**

(72) Inventor : **Sahyun, Melville R., c/o Minnesota Mining and**
**Manufact. Co., 2501 Hudson Road, P.O. Box 33427**
**St. Paul, Minnesota 55133-3427 (US)**
Inventor : **Crooks, Gwen P., c/o Minnesota Mining and**
**Manufact. Co., 2501 Hudson Road, P.O. Box 33427**
**St. Paul, Minnesota 55133-3427 (US)**

(74) Representative : **Ahner, Francis**
**CABINET REGIMBEAU, 26, avenue Kléber**
**F-75116 Paris (FR)**

## (54) Improved sensitization of photopolymerizable compositions.

(57) Photopolymerizable compositions containing free-radically polymerizable monomer, diaryl iodonium or triaryl sulfonium complex salts, and certain 1,3,5-tri(monoaryl)-2-pyrazolines. In dual-curable systems, epoxides are also polymerized.

The inventive photopolymerizable compositions exhibit high photosensitivities and are relatively unaffected by the presence of oxygen.

EP 0 530 095 A1

## Field of the Invention

This invention relates to a free-radically photopolymerizable composition and more particularly, it relates to such a composition utilizing certain 1,3,5-tri(monoaryl)-2-pyrazolines as sensitizers. This invention also relates to dual-curable, photopolymerizable compositions containing both free-radically polymerizable monomer and epoxy resin utilizing certain 1,3,5-tri(monoaryl)-2-pyrazolines as sensitizers.

## Background of the Invention

Free-radical polymerization of ethylenically unsaturated monomers, e.g., vinyl and acrylic monomers, is well known. Photoinitiators such as aromatic iodonium or sulfonium complex salts are commonly utilized in conjunction with a photosensitizer such as a dye, e.g. coumarin or ketocoumarin compounds.

In the foregoing photopolymerizable systems, the sensitizer typically effects a one-electron reduction of the onium photoinitiator. The resulting radical derived from the initiator then yields the actual free-radical polymerization initiating species. A major source of inefficiency, though, in this reaction pathway is "back electron transfer" from the free-radical initiating species to reform the initiator and the ground state of the sensitizer, thereby slowing down the photopolymerization reaction. Oxygen is also known to inhibit free-radical polymerization reactions since oxygen can act as a free-radical scavenger.

In the past, improvements in photosensitizers have been sought. For example, U.S. Patent No. 4,250,053 discloses photosensitive mixtures containing an aromatic iodonium or sulfonium compound and a sensitizer selected from the class of polyarylenes; 2,5-diphenylisobenzofurans; 2,5-diarylcyclopentadienes; diarylfurans; diarylthiofurans, diarylpyrrolidones; polyarylphenylenes; coumarins; and polyaryl-2-pyrazolines. Specifically disclosed are diaryl-2-pyrazolines wherein the aryl groups may be substituted or unsubstituted phenyl or polyaryl (e.g., naphthyl or anthryl) as well as 1,3,5-triaryl-2-pyrazolines wherein one or more of the aryl groups are polyaryl and/or monoaryl, the monoaryl groups being attached to the pyrazoline ring through an alkylene group, e.g., as in the case of styryl. In particular, see Compounds 49-58 disclosed at column 8 of the '053 patent.

Whereas the foregoing disclosed photosensitizers are operable, especially for the initiation of cationic polymerization, development of photopolymerizable compositions with photoinitiators and photosensitizers which minimize the "back electron transfer" problem and which exhibit decreased sensitivity to oxygen is desirable and continuously sought by those in the industry.

## Summary of the Invention

By the present invention, it has now been discovered that certain 1,3,5-tri(monoaryl)-2-pyrazolines are highly efficient photosensitizers for the polymerization of free-radically polymerizable monomers. Thus, in one embodiment, the present invention provides a free-radically photopolymerizable composition which comprises:

(a) free-radically polymerizable monomer; and

(b) a photoinitiator system, soluble in the monomer, comprising photochemically effective amounts of

(i) diaryliodonium or triaryl sulfonium complex salts; and

(ii) 1,3,5-tri(monoaryl)-2-pyrazolines wherein the monoaryl radicals contain up to 6 ring atoms optionally substituted with non-electron withdrawing substituents (e.g., $C_1$ to $C_6$ alkyl, $C_1$ to $C_6$ alkoxy, $C_1$ to $C_6$ alkylamino, and halogen groups provided that the halogen groups are present on only one of the three monoaryl radicals.

Additionally, it has now been discovered that the above-disclosed 1,3,5-tri(monoaryl)-2-pyrazolines are highly efficient photosensitizers as well for the polymerization of both free-radically polymerizable monomer and epoxy resin, the latter being photopolymerized by a cationic rather than free-radical based mechanism. Accordingly, in another embodiment the present invention provides a "dual-curable", photopolymerizable composition which comprises:

(a) free-radically polymerizable monomer;

(b) epoxide; and

(c) a photoinitiator system, soluble in the free-radically polymerizable monomer and epoxide, comprising photochemically effective amounts of:

(i) diaryliodonium or triaryl sulfonium complex salts; and

(ii) 1,3,5-tri(monoaryl)-2-pyrazolines wherein the monoaryl radicals contain up to 6 ring atoms optionally substituted with non-electron withdrawing substituents (e.g., $C_1$ to $C_6$ alkyl, $C_1$ to $C_6$ alkoxy, $C_1$ to $C_6$ alkylamino, and halogen groups such that the halogen groups are present on only one of the three monoaryl radicals.

The present invention provides photopolymerizable compositions with higher photospeeds and reduced susceptibility to inhibition of polymerization by oxygen compared to other compositions sensitized with various sensitizers known in the art including certain diaryland triaryl-pyrazolines, such as those disclosed by U.S. Patent No. 4,250,053.

Other aspects and benefits of the present invention are apparent from the detailed description, examples, and claims.

Detailed Description of the Invention

A wide variety of free-radically polymerizable monomers can be employed. Suitable monomers contain at least one ethylenically-unsaturated double bond, can be oligomers, and are capable of undergoing free-radical polymerization. Such monomers include mono-, di- or poly-acrylates and methacrylates such as methyl acrylate, methyl methacrylate, ethyl acrylate, isopropyl methacrylate, n-hexyl acrylate, stearyl acrylate, allyl acrylate, glycerol diacrylate, glycerol triacrylate, ethyleneglycol diacrylate, diethyleneglycol diacrylate, triethyleneglycol dimethacrylate, 1,3-propanediol diacrylate, 1,3-propanediol dimethacrylate, trimethylolpropane triacrylate, 1,2,4-butanetriol trimethacrylate, 1,4-cyclohexanediol diacrylate, pentaerythritol triacrylate, pentaerythritol tetraacrylate, pentaerythritol tetramethacrylate, sorbitol hexacrylate,bis[1-(2-acryloxy)]-p-thioxy-penyldimethylmethane, bis[1-(3-acryloxy-2-hydroxy)]-p-propoxy-phenyldimethylmethane, trihydroxyethyl-isocyanurate triacrylate; the bis-acrylates and bis-methacrylates of polyethylene glycols of molecular weight 200-500, copolymerizable mixtures of acrylates monomers such as those of U.S. Patent No. 4,652,274, and acrylated oligomers such as those of U.S. Patent No. 4,642,126; unsaturated amides such as methylene bis-acrylamide, methylene bis-methacrylamide, 1,6-hexamethylene bis-acrylamide, diethylenetriamine tris-acrylamide and betamethacrylaminoethyl methacrylate; and vinyl compounds such as styrene, diallyl phthalate, divinyl succinate, divinyl adipate, and divinyl phthalate. Mixtures of two or more monomers can be used if desired.

The monomer is combined with a two component or binary photoinitiator system. The first component in the photoinitiator system is a diaryl iodonium or triaryl sulfonium complex salt.

Aromatic iodonium salts which can be sensitized in accordance with this invention include those having the formulae:

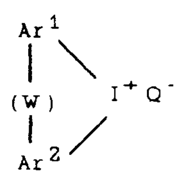

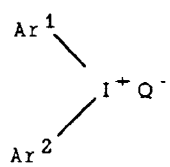

wherein:

$Ar^1$ and $Ar^2$ are aryl having 4 to 20 carbon atoms and are preferably selected from phenyl, naphthyl, thienyl, furanyl, and pyrazolyl;

W is selected from

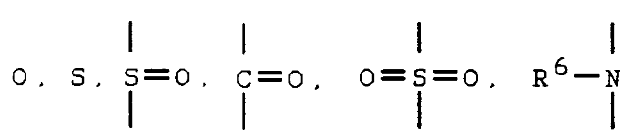

where $R^6$ is aryl of 6 to 20 carbon atoms or acyl of 2 to 20 carbon atoms (such as substituted or unsubstituted phenyl, acyl, benzoyl, etc.); a carbon-to-carbon bond; or

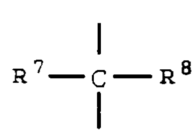

where $R^7$ and $R^8$ are selected from hydrogen, alkyl of 1 to 4 carbon atoms, and alkenyl of 2 to 4 carbon atoms;

and Q is halogen-containing complex anion selected from tetra-fluoroborate, hexafluorophosphate, hexafluoroarsenate, and hexafluoroantimmomate. Amongst the useful iodonium salts are particularly included diphenyliodonium iodide, diphenyliodonium hexafluoroantimonate, 4-chlorophenylphenyliodonium tetrafluoroborate, di(4-chlorophenyl)iodonium hexafluoroantimonate, diphenyliodonium hexafluorophosphate, diphenyliodonium trifluoroacetate, 4-trifluoromethylphenylphenyliononium tetrafluoroborate, diphenyliodonium hexafluoroarsenate, ditolyliodonium hexafluorophosphate, di(4-methoxyphenyl)iodonium hexafluoroantimonate, di(4-methoxyphenyl)iodonium chloride, (4-methyl-phenyl)phenyliodonium tetrafluoroborate, di(2,4-dimethylphenyl)iodonium hexafluoroantimonate, di(4-t-butylphenyl)iodonium hexafluoroantimonate, and 2,2'-diphenyliodonium hexafluorophosphate.

Aromatic sulfonium compounds which can be sensitized in accordance with this invention include those having the formulae:

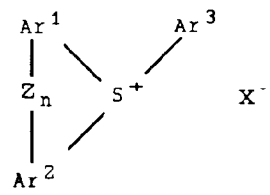

or

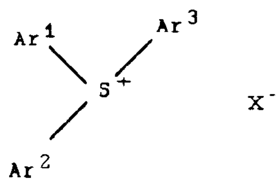

wherein $A^1$, $A^2$, and $A^3$ are independantly aryl having 4 to 20 carbon atoms (e.g., substituted or unsubstituted phenyl, naphthyl, thienyl, and furanyl). Substitution may be with such groups as alkoxy, alkylthio, arylthio, halogens, etc., and alkyl radicals having 1 to 20 carbon atoms. The term "alkyl" as used here is meant to include substituted alkyl radicals (for example, with substituents such as halogen, hydroxy, alkoxy, and aryl). Z is selected from the group consisting of oxygen; sulfur;

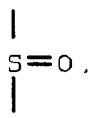, 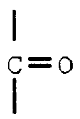, 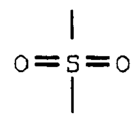, and 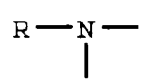

wherein R is aryl (of 6 to 20 carbons, such as phenyl) or acyl (of 2 to 20 carbons, such as acetyl, benzoyl, etc.); a carbon-to-carbon bond; or

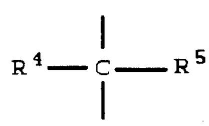

where $R^4$ and $R^5$ are selected from the group consisting of hydrogen, an alkyl radical having 1 to 4 carbon atoms, and an alkenyl radical having 2 to 4 carbon atoms; and n is zero or 1; and $X^-$ is a halogen-containing complex such as halogen-containing complex salt where X is selected from tetrafluoroborate, hexafluorophosphate, hexafluoroarsenate, hexafluoroantimonate, and hydroxypentafluoroantimonate (e.g., for photoinitiation of cationically polymerizable materials such as epoxy resins or epoxy resins and polyols).

Aromatic sulfonium salts are known and recognized in the art. Triaryl-substituted sulfonium compounds, for example, can be prepared by the procedures described in C. H. Wiegand et al., "Synthesis and Reactions of Triarylsulfonium Halides", J. Org. Chem. 33, 2671-75 (1968). Aromatic sulfonium salts also having alkyl- substitution can be prepared by the procedures described in K. Ohkubo et al., J. Org. Chem. 36, 3148-55 (1971). The preferred method for making triaryl-substituted sulfonium compounds is described in U.S. Patent No. 2,807,648 from which complex sulfonium salts can be made. The complex sulfonium salts can be prepared from the corresponding simple salts, such as the bisulfate or halide salts, by metathesis with a metal or ammonium salt or acid of the complex anion desired.

The sulfonium complex salts are substituted with at least one, and preferably three, aromatic groups. Representative groups are aromatic groups having 4 to 20 carbon atoms and are selected from phenyl, thienyl and furanyl groups. These aromatic groups may optionally have one or more fused benzo rings (e.g., naphthyl and the like, benzothienyl, dibenzothienyl, benzofuranyl, dibenzofuranyl, etc.). Such aromatic groups may also be substituted if desired, by one or more of the following groups, or by other groups which are essentially nonreactive with other components present in the particular composition in which the complex salt is to be used: halogen, nitro, aryl, ester groups (e.g., alkoxycarbonyl such as methoxycarbonyl and ethoxycarbonyl, phenoxycarbonyl, and acryloxy such as acetoxy and propionyloxy), alkoxy groups (e.g., methoxy, ethoxy, butoxy and the like), aryl groups (e.g., phenyl), alkyl groups (e.g., methyl, ethyl, 1-butyl and the like) aryloxy groups (e.g., phenoxy), alkyl-sulfonyl (e.g., methylsulfonyl, ethylsulfonyl, and the like), arylsulfonyl groups (e.g., phenylsulfonyl groups), hydrocarbylthio groups (e.g., p-phenylthio, methylthio, etc.), pefluoroalkyl groups (e.g., trifluoromethyl, perfluoroethyl, and the like), and perfluoroalkyl sulfonyl groups (e.g., trifluoromethylsulfonyl, perfluorobutylsulfonyl, and the like).

Examples of suitable aromatic sulfonium complex salt photoinitiators include: triphenylsulfonium tetrafluoroborate, methyldiphenylsulfonium tetrafluoroborate, dimethylphenylsulfonium hexafluorophosphate, triphenylfulfonium hexafluorophosphate, triphenylsulfonium hexafluoroantimonate, diphenylnaphthylsulfonium hexafluoroarsenate, tritolysulfonium hexafluorophosphate, anisyldiphenylsulfonium hexafluoroantimonate, 4-butoxyphenyldiphenylsulfonium tetrafluoroborate, 4-chlorophenyldiphenylsulfonium hexafluorophosphate, tri (4-phenoxyphenyl)sulfonium hexalfuorophosphate, di (4-ethoxyphenyl) methylsulfonium hexafluoroarsenate, 4-acetonylphenyldiphenylsulfonium tetrafluoroborate, 4-thiomethoxyphenyldiphenylsulfonium hexafluorophosphate, di(methoxysulfonium phenyl)methylsulfonium hexafluoroantimonate, di(nitrophenyl)phenylsulfonium hexafluoroantimonate, di(carbomethoxyphenyl)methoylsufonium hexaflurophosphate, 4-acetamidophenyldiphenylsulfonium tetrafluoroborate, dimethylnaphthylsulfonium hexafluorophosphate, trifluoromethyldiphenylsulfonium tetrafluoroborate, p-(phenylthiophenyl)diphenylsulfonium hexafluoroantimonate, 10-methylphenoxathionium hexafluorophosphate, 5-methylthiantrenium hexafluorophosphate, 10-phenyl-9,9-dimethylthioxanthenium hexafluorophosphate, 10-phenyl-9-oxothioxanthenium tetrafluoroborate, 5-methyl-10-oxothianthrenium tetrafluoroborate, and 5-methyl-10,10-dioxothianthrenium hexafluorophosphate.

Of the aromatic sulfonium complex salts which are used in this invention the preferred salts are the triaryl-substituted salts such as triphenylsulfonium hexafluorophosphate, p(phenylthiophenyl)diphenylsulfonium hexafluoroantimonate and triphenylsulfonium hexafluoroantimonate. The triaryl-substituted salts are preferred because they are more thermally stable than the mono- and diaryl-substituted salts and accordingly, may be used in one-part curable systems where long shelf life is desired.

The amount of latent photocatalytic onium salt used in photopolymerizable compositions of the invention is not critical but can be from about 0.01 to about 10.0% by weight of polymerizable material and preferably 0.1 to 5% by weight of the total weight of polymerizable material. Use of greater amounts of onium salt generally does not afford increased polymerization and use of less tends to reduce the extent of polymerization. A method for predicting the optimum combination of onium complex salt initiator to be added for a particular application has been taught by Timpe and coworkers (H.J. Timpe et al., J. Photochem. and Photobiology, A:Chem, 52, 111 (1990)).

The 1,3,5-tri(monoaryl)-2-pyrazolines used in the present invention have the following formula:

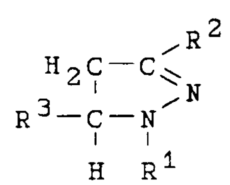

wherein $R^1$, $R^2$, and $R^3$ each independently represent monoaryl (e.g., phenyl, pyridyl, thiophenyl, etc.) containing up to 6 ring atoms and are optionally substituted with non-electron withdrawing groups such as, for example, $C_1$ to $C_6$ alkyl, $C_1$ to $C_6$ alkoxy, $C_1$ to $C_6$ alkylamino or halogen groups such as chloro, bromo, or iodo, provided that the halogen gorups are present on only one of the thre monoaryl radicals.

Examples of pyrazolines which can be utilized in the present invention can be found in Table I of the examples which follow. The pyrazolines used in the present invention can be synthesized according to synthetic mechanisms well known to those skilled in the art.

Preferably, from about 0.1 to 10 weight percent and most preferably from about 0.5 to 2.5 weight percent of pyrazoline is utilized in the present invention, based upon the total weight of polymerizable material (excluding solvents).

As disclosed herein earlier, it is also within the scope of the present invention to simultaneously photopolymerizable both free-radically polymerizable monomer and epoxide (i.e., a dual curable system) in the presence of the foregoing disclosed onium complex metal salts and pyrazolines. Simultaneous initiation of free-radically polymerizable monomer and epoxy resin in a mixture can result in the formation of a simultaneous interpenetrating polymer network (SIPN). Broadly, SIPN's can be defined as a polymer alloy of two (or more)

distinct polymers resulting from the simultaneous polymerization of two (or more) different types of monomers (e.g., free-radically polymerizable monomer and epoxy resin) by way of noninterfering modes. Onium initiators are particularly useful in effecting such simultaneous polymerizations because their cleavage yields both radicals and protic acids. For a thorough discussion of SIPN's, see H.F. Mark et al., Encyclopedia of Polymer Science and Engineering, 8, 288-294 (1987).

The epoxides which can be employed in the present invention contain at least one epoxy group having the formula:

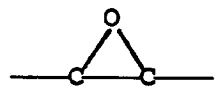

The epoxy groups can be terminal epoxy groups or internal epoxy groups. The epoxides are primarily cycloaliphatic epoxides, such as the compounds prepared by epoxidation of multicycloalkenyls (polycyclic aliphatic compounds containing carbon-carbon double bonds) with organic peracids ( such as peracetic acid) or hydrogen peroxide. The cycloaliphatic epoxide resins may be blended with minor amounts of glycidyl type epoxides, a liphatic epoxides, epoxy cresol novolac resins, polynuclear phenol-glycidyl ether-derived resins, aromatic and heterocyclic glycidyl amine-resins, hydantoin epoxy resins, and the like.

When the dual cure systems are used, the amounts of photopolymerizable material (free-radically polymerized monomer and epoxide), onium photoinitiator, and pyrazoline sensitizer are the same as disclosed earlier herein.

The photopolymerizable compositions of the present invention, as shown by the data later herein, are relatively unaffected by the presence of oxygen.

Compositions of the invention can be used for preparation of coatings for various substrates; however, adhesives, sealants, binders and rubbers can also be prepared form the compositions of the invention and are particularly useful where such materials need be polymerized in situ by irradiation. Compositions of the invention can be applied to substrates by spraying, brushing, dipping, roller coating, flow coating or any of the methods used in commercial coating operations.

Compositions of the invention may contain certain additives to alter the properties of the polymerized or cured product. Thus, there may be added dyes, pigments, plasticizers, fillers and the like as long as these materials do not prevent the sensitizers from absorbing sufficient radiation to effect polymerization.

Polymerization or curing of the composition is a triggered reaction, i.e., once light exposure of the photocatalytic onium salt has been initiated, the polymerization or curing proceeds and will continue even after terminating irradiation. The use of thermal energy during or after exposure to radiation may greatly accelerate polymerization or curing.

The following non-limiting examples further illustrate the present invention.

Example 1

Utility of the pyrazoline compounds of Table I below as sensitizers was illustrated in photopolymer lithoplate constructions, the formulations of which are given in Table II below; the U-34 urethane oligomer was prepared according to the teachings of U.S. Patent No. 4,228,232.

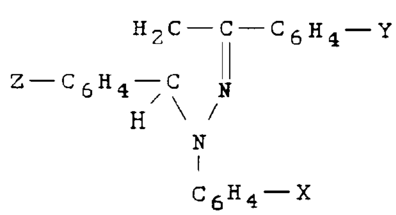

1,3,5-triaryl-2-pyrazolines

Table I

Representative 1,3,5-triaryl-2-pyrazolines

| Compound | X | Y | Z |
|---|---|---|---|
| 1 | H[a] | H | H |
| 2 | H | H | 4-N,N-dimethylamino |
| 3 | H | H | 4-methoxy |
| 4 | H | H | 4-methyl |
| 5 | H | H | 4-chloro |
| 6 | H | H | 4-cyano |
| 7 | H | H | 4-nitro |
| 8 | H | H | 3,4-methylenedioxy |
| 9 | H | H | 4-octyloxy |
| 10 | 3,4-dichloro | H | 2,6-dichloro |
| 11 | H | H | 2,6-dichloro |
| 12 | 3,4-dichloro | H | 4-octyloxy |
| 13 | 4-nitro | H | 4-N,N-dimethylamino |
| 14 | H | 4-methoxy | 4-nitro |
| 15 | H | 4-methoxy | H |

[a] indicates all ring substituents are hydrogen unless indicated otherwise

In the above Table I, compounds 6, 7, 10, 13, and 14 represent pyrazolines whose use would not be within the scope of the present invention and thus, are comparative examples.

To 5 g of the composition of Table II was added 6 mg of a pyrazoline of Table I and 20 mg of (a) diphenyliodonium hexafluorophosphate, or (b) triphenylsulfonium hexafluorophosphate, or (c) tris-(trichloromethyl)-s-triazine. The sensitized composition was coated on commercial grained aluminum stock with a #22 gauge wire-round rod (available from RD Specialties; Webster, New York). After the polymerizable coating dried (room temperature), it was overcoated with an aqueous solution of 5% polyvinylalcohol, using a #16 gauge rod. Coatings were oven dried for two minutes at 60-70°C and allowed to equilibrate with the ambient environment before evaluation. Control coatings employing anthracene sensitizer in the same concentration as the pyrazolines was prepared in identical fashion.

Samples of the coatings were exposed through a Stouffer sensitivity guide (square root of 2 step tablet) in a Berkey-Ascor vacuum frame (Berkey Technical Co., Woodside, NY) (medium pressure Hg source with principal emission at 366 nm) for 2.7 sec. Speeds are expressed as number of "solid" steps left on the plate sample after wash-off development of the negative image in a standard caustic developer. Results are reported in Table III below; a speed of 12 steps corresponds to a working exposure of about 5000 erg/$cm^2$ at 366 nm.

Table II

Standard lithoplate formulation

| Ingredient | Amount (grams) |
|---|---|
| Pentaerythritol tetraacrylate | 2.0 |
| U-34 urethane oligomer | 1.4 (50% in MEK) |
| N-Propanol aq. azeotrope (70 wt. 4 n-propanol/30 wt. water) | 26.6 |
| Triethylamine | 0.07 |
| Klucel-M[a] (1.5% in n-propanol azeotrope) | 12.5 |
| Blue pigment dispersion[b] | 2.0 |

[a] a modified cellulose polymer, Hercules, Inc., Wilmington, DE.

[b] the pigment dispersion in 1-propanol was prepared from commercial Sunfast Blue pigment and Formvar 12/85 (Monsanto Co., St. Louis, MO) in a ratio of 1:2 dissolved in the propanol-aqueous azeotrope to make a dispersion 13.7% by weight solids.

TABLE III

Speeds of printing plate formulations

| Sensitizer (Table II) | Speeds with initiator: $Ph_2I^+$ | $Ph_3S^+$ | Triazine |
|---|---|---|---|
| 1 | 13 | 9 | 15 |
| 2 | 13 | 8 | 11 |
| 3 | 10 | 9 | 13 |
| 4 | 12 | 9 | 12 |
| 5 | 11 | 9 | 14 |
| 6 | 8 | 5 | 10 |
| 7 | 3 | 1 | 6 |
| Anthracene (a) | 4 | 3 | 7 |

(a) 15 sec exposure

Results of Table III show that Compounds 1-5 (within the scope of the present invention) provide useful compositions while Compounds 6 and 7 (outside the scope of the present invention) exhibit inferior sensitivity.

Example 2

This example shows that not only are the compositions useful when freshly prepared, but they maintain their functionality on long term standing without need for special protective precautions during storage.

Coatings were prepared according to the method of Example 1, using sensitizers 2, 3, 4, and 5 and each of the three initiators. Samples were exposed for 12 sec under otherwise the same conditions as in Example 1; after development, photographic speeds were read as in Example 1 and the results were averaged for the four samples (which appeared equivalent in sensitizing efficiency in the experiment of Example 1).

The samples were stored in the dark under ambient laboratory conditions of atmosphere and temperature

and re-evaluated, as above, at three month intervals. In addition, at the time of the last evaluation, the samples were reequilibrated with air after contacting the step tablet, but before exposure, in order to evaluate the inhibiting effect of air on the photochemistry. Results of these tests are reported in Table IV.

TABLE IV

Speeds of printing plate formulations

| Age | Speeds with initiator: | | |
|---|---|---|---|
| | $Ph_2I^+$ | $Ph_3S^+$ | Triazine |
| Freshly coated | 16.8 ± .4 | 14.2 ± .5 | 18 ± 1.6 |
| 3 months | 14.5 ± .5 | 13.5 ± 1 | 15.5 ± 1.1 |
| 6 months (exposed in air) | 14.5 ± .5 | 13.5 ± .9 | 12 ± 2 |

These results show that, surprisingly, combinations of the sensitizers with the triazine initiator of Example 1, although yielding higher initial speeds than the combinations of the invention, do not provide the shelf stability or the insensitivity to oxygen quenching of the inventive compositions.

Example 3

This example compares compositions of this invention (Compound 4, Table I) to those in U. S. Patent No. 4,250,053 (Compounds 34 and 49), as follows:

Compound 34 of U. S. Patent No. 4,250,053 was prepared by the method of Schafer and Tollens (Chem. Ber. 39: 2181 (1906)) and Compound 49 of U. S. Patent No. 4,250,053 was prepared and purified by the same method used for the sample reported by Smith in that patent.

To 15 g aliquots of a composition prepared according to Table II of Example 1, were added 20 mg portions of sensitizers 4, 34, and 49. Sensitized solutions were first coated, then overcoated with a topcoat of polyvinylalcohol, dried, exposed 15 sec, and developed as described in Example 1. Photographic speeds evaluated as in Table III are reported in Table V for samples exposed in vacuo and reequilibrated with air.

TABLE V

Comparison of in air and in vacuo exposures

| Sensitizer | Speed point (steps) | |
|---|---|---|
| | in vacuo | in air |
| 4 | 10 ± 1 | 12 ± 1 |
| 34 | 7 | 5 |
| 49 | 1 | no image |

Results of Table V demonstrate that compositions of the present invention (No. 4) exhibit enhanced speed in free-radical cures, relative to compositions (Nos. 34 and 49) of U. S. Patent No. 4,250,053 and that compositions of the present invention are also uniquely insensitive to oxygen inhibition.

The following two examples (Examples 4 and 5) describe dual curable compositions according to the present invention.

Example 4

A solution was prepared from 0.35 g Quatrex® 1010 (a bifunctional epoxy monomer, Dow Chemical Co., Midland, MI) 0.35 g trimethylolpropane triacrylate, 0.15 g triphenylsulfonium hexafluoroantimonate (30 wt. % in methylene chlorine), and 25 mg 1,3,5-triphenyl-2-pyrazoline (Compound 4) all dissolved in 2 g methylene chloride. The resulting solution was coated to a thickness of ca. 5μm on polyester film base using a 40 gauge (number) wire-wound rod. After air drying, the coating was laminated with a cover sheet comprising a 1 mil

thick cast polypropylene foil (Specialty Film Division, 3M, St. Paul, MN).

A sample of the covered coating was exposed 1 min in the Berkey-Ascor vacuum frame through the step tablet. After exposure, the cover sheet was peeled off; the uncured photopolymer, corresponding to exposures through step 14 and below transferred to the polyropylene. The photopolymer receiving exposures corresponding to step 8 or greater was hard and resistant to wash-off with either ethanol or 2-butanone. Between steps 8 and 14 was an extended "ghost" region, in which the polymer was soft and solvent swellable. It is inferred that both monomer systems cured at exposures greater than that corresponding to step 8 to yield an SIPN; between steps 8 and 14 only one monomer, most likely the acrylic, was cured. To support this interpretation, the experiment was repeated; the trifunctional acrylic monomer was, however, left out. Wash-off development of the sensitometrically exposed sample indicated that the epoxy polymer was cured at exposures corresponding to step 8 or above without a "ghost" regime.

Example 5

To a solution of 1 9 ERL-4221 epoxy monomer (a cyclohexene oxide, Union Carbide Co., Charleston, WV), 1 g methyl acrylate, and 0.3 g triphenylsulfonium hexafluoroantimonate (30 4 in methylene chloride) was added 1 ml of a solution of Compound 4, 1 x $10^{-4}$ M in methylene chloride. The solution, in a 1 cm quartz spectrophotometer cuvette, was purged of oxygen by passage of dry argon for 5 min, then sealed. The sample was then irradiated 5 min in front of a 1 kW Xe lamp, at which time there was noticeable polymer build-up along the optical path of the light. Aliquots of the solution, before and after irradiation, were analyzed by 400 MHz proton nmr spectrometry with the results given in Table VI.

TABLE VI

NMR Analysis of epoxy-acrylate solution

| ppm | Assignment | Integrated Areas (rel.) Unirradiated | Irradiated |
|---|---|---|---|
| 1.2-2.1 | cyclohexene (std.) | 64 (100) | 71 (100) |
| 3.1 | epoxy | 19 (30) | 18 (25) |
| 3.65 | acrylic polymer | 1 (1.6) | 4 (5.6) |
| 3.75 | acrylic monomer | 29 (45) | 26 (36) |

Results of Table VI show that even at relatively low degrees of conversion, polymerization of both the epoxy and acrylic monomers proceeds in parallel, when photocuring is carried out according to the practice of the invention.

Example 6

This example illustrates utility of additional 1,3,5-triphenyl-2-pyrazolines, specifically compounds 8-14 of Table I which were prepared as described above with substitution on both 1- and 5-rings.

Pyrazolines listed in Table I were introduced into the photopolymer test formulation of Table II, at the level of 20 mg per 10 g aliquot of standard composition. Diphenyliodonium hexafluorophosphate was also added as initiator in each test sample at the level of 30 mg per 10g aliquot. Photopolymer solutions were coated with a 136 gauge wire wound rod (R. D. Specialties, Webster, NY) onto grained aluminum lithoplate stock and the coatings were air dried. They were then overcoated with a 3 wt.% aqueous solution of polyvinylalcohol using a #12 gauge wire wound rod. The coatings were dried for 2 min at 90°C. Coated samples were evaluated according to the procedure of Example 1. Photoimaging speeds are reported as number of solid steps reproduced from the step tablet, remaining after wash-off development, in Table VII.

TABLE VII

Photopolymer imaging speeds obtained with polysubstituted 1,3,5-triaryl-2-pyrazolines

| Compound | Speed (solid steps) |
|---|---|
| 9 | 9 |
| 10 | no image |
| 11 | 7 |
| 12 | 10 |
| 13 | no image |
| 14 | 1 |

Results of Table VII show that useful triaryl-2-pyrazolines can accommodate substituents on any of the aryl rings, in the o-, m- or p-positions, and can also accommodate patterns of multiple substitution. As seen in Example 1, pyrazolines bearing strongly electron withdrawing groups, e.g. nitro (as in Compound 13), on any of the rings, or combinations of several weakly electron withdrawing groups, e.g. four chlorine substituents as in Compound 12, are not useful in the practice of the invention.

Example 7

U.S. Patent 4,250,053 teaches the utility of 1,3,5-triaryl-2-pyrazolines, in which one or more of the aromatic rings is bi- or polycyclic, as sensitizers for photolysis of onium salts useful in the initiation of free-radical or cationic polymerization. Utility of these compositions are not illustrated by example in U.S. Patent No. 4,250,053.

In order to compare the teaching of U.S. Patent No. 4,250,053 with that of the present invention, compounds 55, 56 and 58 of that disclosure were prepared by the methods cited therein. Compound 55 is 1-phenyl-3-(2-naphthyl)-5-(p-biphenyl)-2-pyrazoline; compound 56 is 1,3-diphenyl-5-(9-anthryl)-2-pyrazoline; and compound 58 is 1,3-diphenyl-5-(2-naphthyl)-2-pyrazoline.

To 40 g of the photopolymerizable composition of Table II was added 0.25 g diphenyliodonium hexafluorophosphate; thereupon it was partitioned into 5 g aliquots. To each aliquot was added 10 $\pm$ 1 mg of a pyrazoline sensitizer. The resulting solutions were coated on grained aluminum with a 26-gauge wire-wound rod; coatings were dried 1 min in an oven at 80°C. Over the photopolymer layers was applied a protective layer comprising 3% aqueous polyvinyl alcohol (medium molecular weight, Aldrich Chemical Co., Milwaukee, WI), with a 16-gauge wire-wound rod. The compositions were then dried 2 min in the same oven.

Portions of the coatings were exposed for 20 sec through a step tablet, in the same exposure device used in Example 1, and developed and read in the same manner as the samples of that Example. In some cases, samples were allowed to re-equilibrate with the ambient atmosphere for 30 sec following contact with the step tablet in the vacuum frame; exposures were then carried out in air to evaluate air sensitivity of the compositions. Speeds of the photopolymer imaging compositions are reported in Table VIII. For comparison with the data of, e.g., Example 1, under these conditions a speed of 18 steps corresponds to a working exposure of about 5000 erg/cm$^2$.

TABLE VIII

Photopolymer imaging speeds

| Sensitizer | in vacuo | in air |
|---|---|---|
| 1 | 18 | 18 |
| 15 | 16 | 17 |
| 55[a] | 9 | --- |
| 56[a] | 6 | --- |
| 58[a] | 15 | 15 |

[a] of U.S. Patent No. 4,250,053

These data demonstrate that pyrazolines of the present invention, bearing substituted or unsubstituted monocyclic aryl groups attached to the 1-, 3-, and 5-positions provide superior photosensitivity than those of the prior art, which incorporate polycyclic substituents.

Reasonable modifications and variations are possible from the foregoing disclosure without departing from either the spirit or scope of the present invention as defined by the claims.

## Claims

1. A free-radically photopolymerizable composition comprising:
   (a) free-radically polymerizable monomer; and
   (b) a photoinitiator system, soluble in said free-radically polymerizable monomer, comprising photochemically effective amounts of
      (i) diaryl iodonium or triaryl sulfonium complex salts; and
      (ii) 1,3,5-tri(monoaryl)-2-pyrazolines wherein the monoaryl radicals contain up to 6 ring atoms and are optionally substituted with non-electron withdrawing substituents.

2. A free-radically photopolymerizable composition according to Claim 1 wherein said free-radically polymerizable monomer contains at least one ethylenically unsaturated group.

3. A free-radically photopolymerizable composition according to Claim 1 wherein said diaryl iodonium complex salt is one selected from the group consisting of:

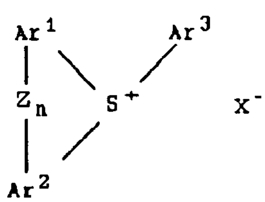

or

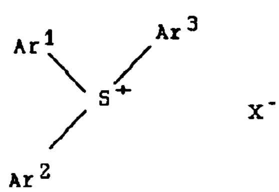

wherein:
   $Ar^1$ and $Ar^2$ are aryl having 4 to 20 carbon atoms;
   W is selected from the group consisting of:

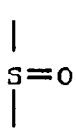 , 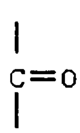 , 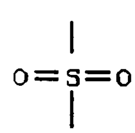 , and 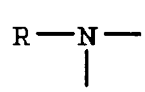

where $R^6$ is aryl of 6 to 20 carbon atoms or acyl of 2 to 20 carbon atoms; a carbon-to-carbon bond; or

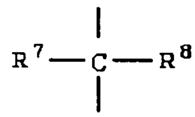

where $R^7$ and $R^8$ are selected from hydrogen, alkyl of 1 to 4 carbon atoms, and alkenyl of 2 to 4 carbon atoms; and Q is a halogen-containing complex ion.

**4.** A free-radically photopolymerizable composition according to Claim 1 wherein said triaryl sulfonium salt is one selected from the group of:

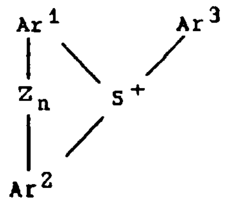 $X^-$ or 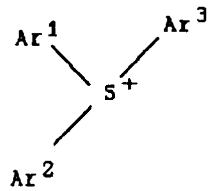 $X^-$

wherein $A^1$, $A^2$, and $A^3$ are independently aryl having 4 to 20 carbon atoms; Z is selected from the group consisting of oxygen; sulfur;

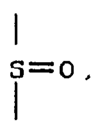 , 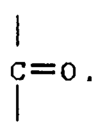 , 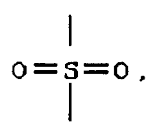 , and 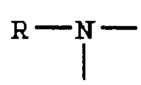

wherein R is aryl of 6 to 20 carbons or acyl of 2 to 20 carbons atoms; a carbon-to-carbon bond; or

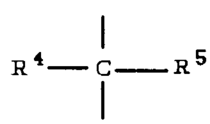

where $R^4$ and $R^5$ are selected from the group consisting of hydrogen, an alkyl radical having 1 to 4 carbon atoms, and an alkenyl radical having 2 to 4 carbon atoms; and n is zero or 1; and $X^-$ is a halogen-containing complex ion.

**5.** A free-radically photopolymerizable composition according to Claim 1 wherein said 1,3,5-tri(monaryl)-2-pyrazoline is represented by the formula:

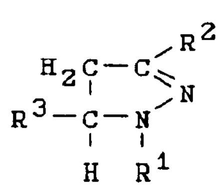

wherein $R^1$, $R^2$, and $R^3$ each independently represent monoaryl containing up to 6 ring atoms and are optionally substituted with non-electron withdrawing groups.

**6.** A dual-curable, photopolymerizable composition comprising:
(a) free-radically polymerizable monomer;
(b) epoxide; and
(c) a photoinitiator system, soluble in said free-radically polymerizable monomer and epoxide, comprising photochemically effective amounts of:
(i) diaryl iodonium or triaryl sulfonium complex salts; and
(ii) 1,3,5-tri(monoaryl)-2-pyrazolines wherein the monoaryl radicals contain up to 6 ring atoms optionally substituted with non-electron withdrawing substituents.

7. A dual-curable, photopolymerizable composition according to Claim 6 wherein said free-radically polymerizable monomer contains at least one ethylenically unsaturated group.

8. A dual-curable, photopolymerizable composition according to Claim 6 wherein said epoxide has at least one epoxy functionality.

9. A dual-curable, photopolymerizable composition according to Claim 6 wherein said diaryl iodonium complex salt is one selected from the group of:

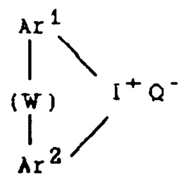

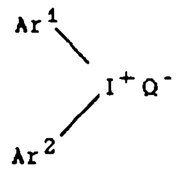

wherein:
A $R^1$ and $Ar^2$ are aryl having 4 to 20 carbon atoms;
W is selected from

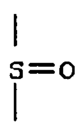 , 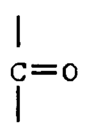 , 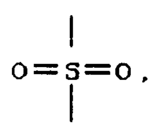 , and 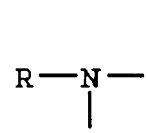

where $R^6$
is aryl of 6 to 20 carbon atoms or acyl of 2 to 20 carbon atoms; a carbon-to-carbon bond; or

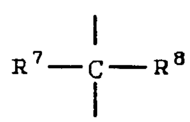

where $R^7$ and $R^8$ are selected from hydrogen, alkyl of 1 to 4 carbon atoms, and alkenyl of 2 to 4 carbon atoms; and Q is a halogen-containing complex anion.

10. A dual-curable, photopolymerizable composition wherein said triaryl sulfonium salt is one selected from the group of:

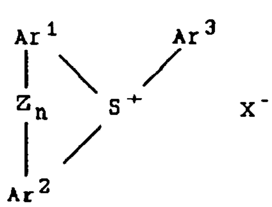

or

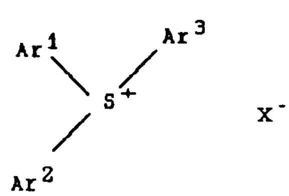

wherein $A^1$, $A^2$, and $A^3$ are each independently aryl having 4 to 20 carbon atoms; Z is selected from the group consisting of oxygen; sulfur;

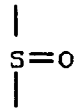, 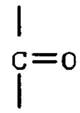, 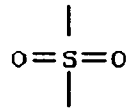, and 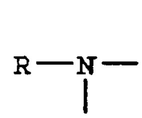

wherein R is aryl of 6 to 20 carbons, or acyl of 2 to 20 carbons; a carbon-to-carbon bond; or

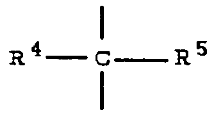

where $R^4$ and $R^5$ are selected from the group consisting of hydrogen, an alkyl radical having 1 to 4 carbon atoms, and an alkenyl radical having 2 to 4 carbon atoms; and n is zero or 1; and $X^-$ is a halogen-containing complex ion.

**11.** A dual-curable, photopolymerizable composition according to Claim 6 wherein said 1,3,5-tri(monoaryl)-2-pyrazoline is represented by the formula:

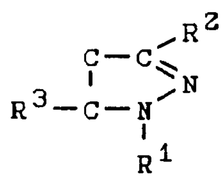

wherein $R^1$, $R^2$, and $R^3$ each independently represent monoaryl radicals containing up to 6 ring atoms and are optionally substituted with non-electron withdrawing groups.

European Patent Office

# EUROPEAN SEARCH REPORT

Application Number

EP 92 40 2336

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| D,X | FR-A-2 457 511 (MINNESOTA MINING AND MANUFACTURING COMPANY)<br>* page 9, line 31 - page 10, line 16 *<br>* page 12, line 1 - line 14 *<br>* claims 1-9 *<br>& US-A-4 250 053 | 1-11 | C08F2/50<br>G03F7/029 |
| P,X | EP-A-0 451 561 (HOECHST)<br>* example 1 * | 1-11 | |
| A | EP-A-0 014 012 (AGFA-GEVAERT) | 1,2,5 | |

TECHNICAL FIELDS SEARCHED (Int. Cl.5 )

C08F
G03F

The present search report has been drawn up for all claims

| Place of search | Date of completion of the search | Examiner |
|---|---|---|
| THE HAGUE | 17 DECEMBER 1992 | ANDRIOLLO G.R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)